# EUROPÄISCHE PATENTSCHRIFT

(11) **EP 0 800 869 B1**
(45) Veröffentlichungstag und Bekanntmachung des Hinweises auf die Patenterteilung: **29.08.2001**
(21) Anmeldenummer: 97103823.7
(22) Anmeldetag: 07.03.1997
(51) Int. Cl.: B05B 11/00

(54) **Austragvorrichtung für Medien**
Fluid discharge device
Dispositif de décharge d'un fluide

(30) Priorität: 16.03.1996 DE 19610457
(43) Veröffentlichungstag der Anmeldung: 15.10.1997
(73) Patentinhaber: Ing. Erich Pfeiffer GmbH, 78315 Radolfzell (DE)
(72) Erfinder: Bommer, Rene Dr., 78315 Radolfzell (DE); Stifel, Michael, 78476 Allensbach-Freudental (DE)
(74) Vertreter: Patentanwälte Ruff, Wilhelm, Beier, Dauster & Partner

(56) Entgegenhaltungen:
- EP-A- 0 363 172
- EP-A- 0 487 412
- EP-A- 0 500 249
- WO-A-94/11115
- US-A- 5 074 440

## Beschreibung

Die Erfindung betrifft eine Austragvorrichtung nach dem Oberbegriff des Anspruches 1. Sie kann zur Speicherung bzw. zum Austrag flüssiger, pastöser, pulverförmiger und/oder gasförmiger Medien geeignet sein. Derartige Medien können pharmazeutische, kosmetische oder technische Wirkstoffe sein, welche zur Anwendung an einem Medienauslaß von der Austragvorrichtung freigegeben werden.

Bei solchen Austragvorrichtungen ist es zweckmäßig, wenn eine Kammer mit einem inerten Füllmedium während des Betriebes nachgefüllt werden kann, beispielsweise um einen Unterdruck auszugleichen. Ein solches gasförmiges Füllmedium, beispielsweise Außenluft, ist im Gegensatz zum inkompressiblen Wirkstoff meist kompressibel. Es füllt nach der teilweisen oder vollständigen Entleerung der Kammer den entstandenen Leerraum z.B. dadurch auf, daß es durch den Unterdruck in der Kammer bis zum Druckausgleich mit der Außenatmosphäre angesaugt wird. Derartige Belüftungsmittel sind daher insbesondere für eine Speicherkammer geeignet, welche eine Vielzahl von Wirkstoffdosen enthält, von denen jede einzeln bei jedem Austragvorgang durch eine Abgabeeinheit aus dem Medienauslaß abgegeben wird. Hierfür kann die Abgabeeinheit eine von der Speicherkammer gesonderte Dosierkammer enthalten. Diese wird nach jedem Austragvorgang aus der Speicherkammer wieder gefüllt und dann beim nachfolgenden Austragvorgang gegenüber der Speicherkammer verschlossen. Dadurch strömt das Medium nicht zurück in die Speicherkammer; sondern zum Medienauslaß. Die Medienkammer kann hierzu unter Druck gesetzt werden, beispielsweise indem ihr Volumen verkleinert und danach zur Ansaugung einer folgenden Mediendosis aus der Speicherkammer wieder vergrößert wird. In der Ruhe- bzw. Ausgangsstellung ist der Medienweg, welcher die Abgabeeinheit von einem Einlaß bis zum Medienauslaß durchsetzt und die Medienkammer einschließt, vorteilhaft druckdicht geschlossen, so daß in die Speicherkammer bzw. die Medienkammer von außen keine Luft eindringen kann.

Um bei Belüftung der Kammer das Eindringen von Partikeln und/oder Keimen zu vermeiden ist zweckmäßig im Belüftungsweg ein Filter vorgesehen. Außerdem ist die Speicherkammer gegenüber der Außenatmosphäre im wesentlichen dicht verschlossen, nämlich über einen Dichtsitz zwischen der Abgabeeinheit und der Speichereinheit. Beim lagestarren Befestigen der Abgabeeinheit an der Speichereinheit werden die Dichtflächen dieses Dichtsitzes unter Pressung aneinander gelegt und gesichert. Dabei wird zweckmäßig zwischen den formsteifen Dichtflächen der Einheiten eine druckelastische, gesonderte Dichteinheit angeordnet. Der Belüftungsweg führt dann nicht durch die Innen- bzw. Gehäuseräume der Abgabeeinheit, sondern ist als Parallelweg vorgesehen, der vollständig gesondert von den Medienwegen und auch von Belüftungswegen ist, die zur Belüftung solcher Gehäuseräume der Abgabeeinheit dienen, die nicht vom Medium beaufschlagt bzw. durchströmt werden. Es kann daher in die zu belüftende Kammer das Füllmedium ausschließlich dadurch gelangen, daß es den Filter durchströmt.

Die volumenveränderbare Kammer kann auch durch die Speicherkammer, beispielsweise eine weiche Quetschflasche, gebildet sein. An deren Hals ist die Abgabeeinheit ständig kommunizierenden Medieneinlaß und davon entfernt einen gesonderten Medienauslaß aufweist. Dadurch kann die Abgabeeinheit auch beim Austrag an der Speicherkammer fest montiert bleiben.

Die WO-A-9 411 115 zeigt Austragvorrichtungen, bei welchen die Filtereinheit mit einem gehäuseförmigen Filterhalter an den Innenumfang des Flaschenhalses der Speichereinheit angelegt ist. Auf den innerhalb des Haltergehäuses liegenden Filter haben die Haltekräfte zwischen Flaschenhals und Haltergehäuse keinen Einfluß.

Der Erfindung liegt die Aufgabe zugrunde, eine Austragvorrichtung zu schaffen, bei welcher Nachteile bekannter Ausbildungen bzw. von Ausbildungen der beschriebenen Art vermieden sind und die insbesondere eine einfache Ausbildung bzw. Montage z.B. so gewährleistet, daß eine sehr raumsparende Anordnung des Filters möglich ist.

Erfindungsgemäß sind die Merkmale nach Anspruch 1 vorgesehen. Die Filtereinheit ist unmittelbar an der Speichereinheit so abgestützt, daß sie erst beim oder nach dem Zusammenbau von Speichereinheit und Austragvorrichtung bzw. Ausgabeeinheit formschlüssig festgelegt, insbesondere zwischen Halteflächen der beiden Einheiten gespannt wird. Die Filtereinheit kann dabei wahlweise mit der die Austragvorrichtung bildenden Abgabeeinheit oder mit der Speichereinheit z.B. so vormontiert werden, daß sie hinsichtlich ihrer Achslage zentriert, durch axialen Anschlag an der Haltefläche jedoch nur in einer Achsrichtung festgelegt ist. Beim Zusammenbau wird die Filtereinheit dann auch an die zweite Haltefläche angelegt und gegenüber dieser zentriert. Bis zum Zusammenbau besteht daher die Wahl, ob ein Filter eingebaut wird oder nicht bzw. welche Art von Filter verwendet wird.

Der Filter kann auch unmittelbar zum dichten Verschluß der Hals- bzw. Speicheröffnung des Speichers so verwendet werden, daß nur der Belüftungsweg durchlässig bleibt. Insbesondere kann der Filter als einzige Dichtung zur Abdichtung des Montagespaltes zwischen Abgabeeinheit und Speichereinheit vorgesehen sein. Dadurch ist eine weitere Dichtung nicht erforderlich. Der Filter liegt vollständig an der Außenseite der Speichereinheit oder der Abgabeeinheit. Letztere ragt in den Speicherhals und die Speicherkammer so hinein, daß diese Außenseite den Speicherraum bis zum Filter begrenzt. Der Filter könnte zwar innerhalb des Speicherhalses liegen, liegt jedoch vorteilhaft auch vollständig an der Außenseite der Speichereinheit, die zweckmäßig nur durch ein einteiliges Gefäß gebildet ist. Der Filter kann dadurch zwischen parallelen Stirnflächen, ggf. aber auch zwischen konzentrischen Umfangsflächen der Speichereinheit und der Abgabeeinheit unter Spannung festgelegt sein.

Unabhängig von der beschriebenen Ausbildung kann eine Filtereinheit aus mehreren Bauteilen, beispielsweise flächigen Lagen, zusammengesetzt sein, von denen eine als Filter und eine als Dichtung ausgebildet und wesentlich dünner als der Filter ist. Die Dichtung ist über ihre gesamte Flächenerstreckung undurchlässig für die Medien, gibt jedoch einen Auslaß des Filters im Randbereich so frei, daß aus diesem Auslaß die Luft in die Speicherkammer strömen kann.

Unabhängig von den beschriebenen Ausbildungen ist zweckmäßig ein scheiben- bzw. plattenförmiger Filter vorgesehen, der auf dem größten Teil seiner Erstreckung zwischen voneinander abgekehrten Kantenflächen parallel zur Plattenebene durchströmt wird. In den Einlaß dieses Filtermaterials kann die Luft parallel und/oder quer zur Plattenebene eintreten. Entsprechend kann die Luft auch aus dem Filtermaterial austreten, wobei hier bevorzugt nur ein axialer Austritt dadurch vorgesehen ist, daß die zugehörige Kantenfläche dicht bzw. unter Pressung vollflächig von der zugehörigen Einheit abgedeckt ist.

Die Abgabeeinheit und die Speichereinheit werden nach dem Zusammensetzen mit einem Befestigungsglied axial und/oder radial gegeneinander verspannt, das zweckmäßig auch auf die Filtereinheit spannend wirkt. Das ring- bzw. kappenförmige Spannglied umgreift die Einheiten am Außenumfang und kann eine Schraubkappe, ein Krimpring oder dgl. sein.

Unabhängig von den beschriebenen Ausbildungen kann der Filter wenigstens teilweise in einer ringförmigen Filterkammer berührungsfrei liegen, die außerhalb der Speichereinheit und/oder der Abgabeeinheit liegt und insbesondere von der Innenseite des Befestigungsgliedes begrenzt ist. Für den Lufteinlaß in die Filterkammer kann das Befestigungsglied von einer Belüftungsöffnung durchsetzt sein.

Unabhängig von den beschriebenen Ausbildungen ist im Belüftungsweg zweckmäßig ein druckabhängig öffnender bzw. schließender Verschluß, wie ein Ventil, vorgesehen. Dessen Schließsitz oder Ventilteil ist unmittelbar durch den Filter gebildet und in Schließlage am Filter abgestützt. Das Ventil kann daher mit dem Filter eine vormontierte Einheit bilden. Vorteilhaft ist der zweite Schließsitz durch die Dichtung gebildet. Ist der zugehörige Ventilteil zum Öffnen und Schließen durch Biegung auslenkbar, so bildet er eine Ventilklappe. Das Filtermaterial und die Dichtung bzw. der Ventilteil können durch Haftung miteinander als Sandwich-Struktur verbunden sein oder nur lose aneinander liegen, so daß sie erst durch die Pressung gegeneinander festgelegt werden.

Vorteilhaft ist als Filter ein Membranfilter, ein Keimfilter bzw. ein gesinterter Filter vorgesehen. Der Filter kann semipermeabel sein, nur Gas und keine Flüssigkeit durchlassen bzw. über seine gesamte Streckung homogen aus einem Filtermaterial bestehen, welches gleichzeitig als Dichtung wirkt.

Durch die erfindungsgemäße Ausbildung kann auf Konservierungsstoffe, die z.B. dem gespeicherten Medium zugemischt sind, vollständig verzichtet werden. Ferner kann durch sämtliche Strömungswege der Abgabeeinheit hindurch keine Luft in die zu belüftende Kammer hinein angesaugt werden. Diese Luft strömt aus der Filtereinheit nur entlang der äußersten, freiliegenden Außenfläche der Abgabeeinheit und des Innenumfanges der Speichereinheit in die Speicherkammer. Ist der Schließsitz des Ventiles durch den Auslaß des Filtermateriales gebildet, so kann dieses auch nicht in Kontakt mit dem Wirkstoff gelangen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ausführungsbeispiele der Erfindung sind in den Zeichnungen dargestellt und werden im folgenden näher erläutert. In den Zeichnungen zeigen:
- Fig. 1: eine erfindungsgemäße Austragvorrichtung in teilweise geschnittener Ansicht,
- Fig. 2: einen Ausschnitt der Fig. 1 in wesentlich vergrößerter Darstellung und abgewandelter Ausbildung.

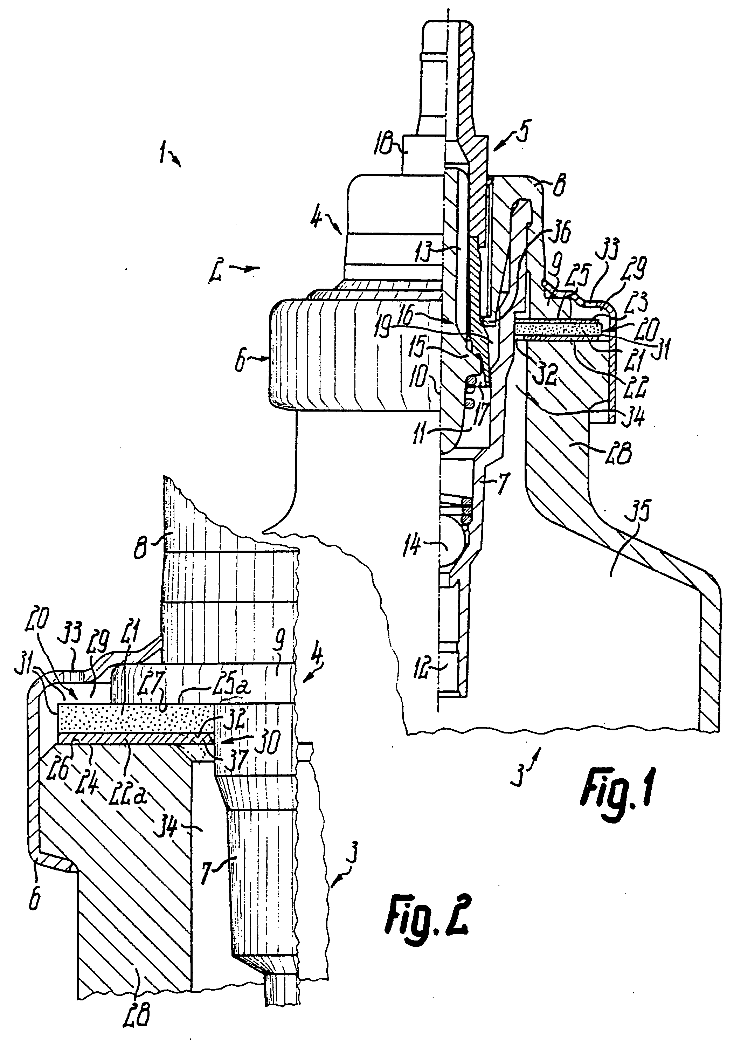

Die Austragvorrichtung 1 gemäß den Figuren 1 und 2 ist in der Ausgangs- bzw. Ruhestellung gezeigt und ist zunächst als funktionstüchtige Abgabeeinheit 2 hergestellt, welche dann fest mit einer Speichereinheit 3 verbunden werden kann. Eine ein- oder mehrteilige Basiseinheit 4 der Einheit 2 wird festsitzend so mit der Einheit 3 verbunden, daß sie mit dem größten Teil ihrer Länge in deren Innenraum hineinragt. In der Einheit 4 ist eine Betätigungseinheit 5 verschiebbar, die aus den Einheiten 3, 4 herausragt und durch die hindurch das Medium bei der Abgabe ins Freie strömt. Die Befestigung der Einheit 4 erfolgt mit einem Befestigungsglied 6, hier einem Krimpring, der nach dem Zusammensetzen der Einheiten 2, 4 und 3 plastisch verformt wird. Das Glied 6 hintergreift dann mit Stirnabschnitten voneinander abgekehrte Stirnflächen der Einheiten 3, 4 formschlüssig. Ein solcher Hintergriff ergibt sich auch im Falle einer Schraubkappe über die ineinander greifenden Gewindeflanken.

Die Einheit 4 bildet ein über seine Länge durchgehend abgestuft hohles Gehäuse. Dessen Mantel 7 ragt mit seinem inneren Ende in den Speicherraum hinein. Das äußere Ende des Mantels 7 ist mit einem Verschluß, beispielsweise einem Deckel 8, abgedeckt. Dieser kann über eine Schnappverbindung mit dem äußeren Rand des Mantels 7 druckdicht verbunden sein. An der Außenseite des Mantels 7 steht eine Ringschulter bzw. ein Ringflansch 9, vor. Er kann einteilig mit dem Mantel 7 oder dem Deckel 8 ausgebildet sein und dient zur axialen Abstützung der Einheit 4 an einer äußersten Endfläche der Einheit 3. Die Einheit 3 ist hier nur durch eine Flasche gebildet. Sie kann durchgehend einteilig ausgebildet sein. Ihre Wandungen sind in jedem Betriebszustand bis auf eine Speicheröffnung durchgehend dicht geschlossen. In die Speicheröffnung ist die Einheit 2, 4 eingesetzt. Das Befestigungsglied 6 hintergreift den Flansch 9 und einen entsprechend vorstehenden Flansch am Außenumfang der Einheit 3. Das Glied 6 richtet die Mittelachse 10 der Einheiten 2 bis 5 gegenüber der Mittelachse der Speicheröffnung achsgleich sowie radialspielfrei aus. Dadurch bleibt zwischen dem Außenumfang des Mantels 7 und dem Innenumfang der Speicheröffnung ein ringförmiger Kanal frei. Er verbindet die Speicheröffnung mit dem Speicherraum permanent. Das Befestigungsglied 6 ist rechts in Fig. 1 vor der Verformung und links in Fig. 1 sowie in Fig. 2 nach der Verformung dargestellt.

Der Innenumfang des Mantels 7 begrenzt eine Medienkammer 11, die hier als Druck- bzw. Pumpenkammer ausgebildet ist. Die Abgabeeinheit 2 ist eine Schubkolbenpumpe. Diese Kammer 11 ist über einen Einlaßkanal 12 mit der Speicherkammer und über einen Auslaßkanal 13 mit dem Medienauslaß leitungsverbunden. Zwischen jedem Kanal 12, 13 und der Kammer 11 ist jeweils ein Ventil vorgesehen. Es liegt vollständig innerhalb des Mantels 7. Die Ventile öffnen in Abhängigkeit vom Betätigungsweg der Einheit 5 und/oder druckabhängig. Das Einlaßventil 14 öffnet bei Unterdruck in der Kammer 11 und das Auslaßventil 15 öffnet bei Überdruck in der Kammer 11. Bei Überdruck in der Kammer 11 schließt das Ventil 14 und bei Unterdruck in der Kammer 11 schließt das Ventil 15. Die Medienwege 11, 12, 13, welche die Speicherkammer mit dem Medienauslaß verbinden, sind dadurch stets durch mindestens ein Ventil druckdicht geschlossen. Der Einlaß 12 ist wie die Ventilkammer des Ventiles 14 von dem Mantel 7 begrenzt. Das Ventil 15 ist vollständig an der Einheit 5 angeordnet, die vom Kanal 13 durchsetzt ist.

Die Einheit 5 enthält eine Kolbeneinheit 16, deren Kolben mit einer Lippe abgedichtet am Innenumfang des Mantels 7 verschiebbar geführt ist, die Kammer 11 am äußeren Ende begrenzt und einteilig mit einem der Ventilteile des Ventiles 15 ausgebildet ist. Der hülsen- bzw. ringförmige Kolben 17 ist an einem Kolbenstößel 18 angeordnet. Dieser durchsetzt das äußere Ende des Gehäuses 7, 8. Auf das äußere, vorstehende Ende des Gliedes 18 kann ein nicht näher dargestellter Betätigungs- und Austragkopf aufgesetzt werden. Er weist den Medienauslaß, z.B. eine Zerstäuberdüse, auf. Dieser Kopf bildet die Handhabe, mit welcher die Einheit 5, 16 entgegen der Kraft einer Rückstellfeder nach innen verschoben werden kann. Dadurch wird das Volumen der Kammer durch den Kolben 17 verkleinert. Die Feder liegt innerhalb der Kammer 11. Bei Erreichen eines entsprechenden Überdruckes in der Kammer 11 wird der Kolben 17 bzw. dessen Ventilteil gegenüber dem übrigen Stößel 18 axial nach außen verschoben. Dadurch wird das Ventil 15 geöffnet. Bei Nachlassen des Druckes schließt eine einteilig mit dem Kolben 17 ausgebildete Ventilfeder das Ventil 15 wieder. Dabei schlagen dessen Schließflächen dann aneinander. Wird der Betätigungskopf von der Betätigungskraft freigegeben, so wird die Einheit 5, 16 durch die Rückstellfeder wieder in ihre Ausgangslage zurückgeführt. In dieser ist die Einheit 5, 16 gegenüber der Einheit 4 durch Anschlag festgelegt. Hinter der Kolbenlippe begrenzen der Kolben 17 und der Innenumfang des Mantels 7 um die Achse 10 einen ringförmigen Raum 19. Dieser ist gegenüber allen Medienwegen durch den Kolben 17 abgedichtet und kann über einen von den Einheiten 4, 5 begrenzten Spalt am äußeren Ende der Einheit 4 mit der Außenatmosphäre leitungsverbunden sein. Dadurch ist der Raum 19 belüftet, jedoch gegenüber der Speicherkammer und den Medienwegen 11 bis 13 ständig abgedichtet. Der Belüftungsweg für den Raum 19 kann in der Ausgangsstellung der Einheit 2 mit einem Ventil gegenüber dem Raum 19 druckdicht verschlossen sein.

Zwischen den Einheiten 2, 3 ist eine Filtereinheit 20 eingespannt, die ein- oder mehrteilig sein kann. Gemäß Fig. 1 ist sie dreiteilig bzw. dreilagig und gemäß Fig. 2 zweilagig. Die platten- bzw. ringscheibenförmige Einheit 20 weist als dickste Lage einen ringscheibenförmigen Filter 21 auf. An dessen beiden Plattenflächen liegt als im wesentlichen durchgehende Abdeckung jeweils eine dünnere Dichtung 22, 23. Die voneinander abgekehrten Flächen dieser äußersten Lagen 22, 23 sind als Gegenflächen 24, 25 vorgesehen. Sie liegen an Halteflächen 26, 27 der Einheit 4 an. Die Haltefläche 26 ist durch die ebene äußerste Endfläche des Speicherhalses 28 gebildet, welche die Speicheröffnung rechtwinklig zur Achse 10 umgibt. Die Haltefläche 27 ist durch die der Haltefläche 26 gegenüberliegende äußerste Stirnfläche des Flansches 9 gebildet und liegt parallel zur Fläche 26. Alle Halteflächen, Gegenflächen und Lagen der Einheit 20 sind um die Achse 10 ringförmig. Die Innenweite der Flächen 26, 27 ist etwa gleich groß und die Außenweite der Fläche 26 ist größer als diejenige der Fläche 27. Die Lagen 21 bis 23 stehen radial nach innen über die Innenweite der Fläche 26, 27 bis zum Außenumfang des Mantels 7 vor, so daß sie an diesem zentriert geführt sind. Die Lagen 21 bis 23 stehen auch über den Außenumfang der Fläche 27 bzw. des Flansches 9 vor, jedoch gegenüber dem Außenumfang der Fläche 26 bzw. des Halsflansches zurück. In diesen Außenumfang greift der Mantel des Befestigungsgliedes 6 zentrierend und daher radialspielfrei ein. Alle Lagen 21 bis 23 sind gemeinsam zwischen den Flächen 26, 27 axial mit Dichtungspressung verspannt. Dadurch ist die Speicherkammer 35 gegen Austritt von Medium durch den Filterweg druckdicht abgeschlossen.

Zwischen den Flächen 26, 27 und zwischen den Lagen 21, 23 kann jedoch Gas in Richtung zur Speicherkammer 35 die Lage 21 durchströmen. Die äußere Kanten- und Umfangsfläche sowie äußere Randzonen der beiden Plattenflächen der Lage 21 bilden dabei den Filtereinlaß 31. Von diesem strömt das Fluid zwischen den Plattenflächen und Lagen radial nach innen und zwar über den gesamten Ringumfang ununterbrochen durchgehend. Die innere Kanten- und Umfangsfläche der Lagen 21 bis 23 kann aufgrund der axialen Spannung durch Quetschung gegen den Außenumfang des Mantels 7 gespannt sein. Die Plattenfläche der Lage 21, die der Fläche 26 bzw. der Kammer 35 zugekehrt ist, liegt teilweise frei. Sie bildet daher im Anschluß an die innere Umfangsfläche den axial in die Kammer 35 gerichteten Filterauslaß 32. Nur durch diesen kann die Luft in die Kammer 35 strömen. Zur Bildung des Auslasses 32 kann die ansonsten dicht geschlossene Lage 22 mit Durchbrüchen versehen sein. Die Durchbrüche können durch eine gezahnte Profilierung des Innenumfanges der Lage 22 gebildet sein, so daß die Zahnspitzen am Mantel 7 anliegen. Durch die Lücken zwischen den Zähnen tritt die Luft in den Ringraum 34 zwischen den Mantel 7 und dem Hals 28 ein. Ansonsten kann an den Plattenflächen der Lage 21 keine Luft austreten. Jede Lage 21 bis 23 weist über ihre gesamte Erstreckung im entspannten Zustand konstante Dicke auf.

Der Einlaß 31 bzw. der äußere Umfangsbereich der Dichtungs- und Filtereinheit 20 liegt nach außen vollständig verkapselt innerhalb einer Kammer 29. Sie ist von der Fläche 26, dem Außenumfang des Flansches 9 und von der Innenseite des dünnwandigen Befestigungsgliedes 6 aus Blech begrenzt. Vom Innenumfang sowie von der Innenseite der Stirnwand des Gliedes 6 hat die Einheit 20 durchgehend Abstand. Einen solchen Abstand hat auch der Einlaß 31 von der Fläche 26. Die ringförmige Filterkammer 29 ist über Öffnungen 33 unmittelbar und permanent an die Außenatmosphäre angeschlossen. Diese Belüftungsöffnungen 33 können Durchbrüche in der Stirnwand des Gliedes 6 sein. Sie liegen zwischen dem Außenumfang des Flansches 9 und dem Mantel des Gliedes 6, so daß die Kammer 29 stets mit Frischluft versorgt ist. Die Stirnwand des Gliedes greift sowohl in die von der Fläche 27 abgekehrte Stirnfläche des Flansches 9 als auch in den Außenumfang des Bauteiles 7, 8 zentrierend ein. Die Öffnungen 33 liegen im Abstand von der Lage 21.

Zur Montage können die Lagen 21 bis 23 einzeln oder als Einheit vom inneren Ende her auf den Mantel 7 aufgesteckt werden, bis sie an der Fläche 27 axial und am Mantel 7 radial im wesentlichen spielfrei oder mit Klemmung anliegen. Auch das Glied 6 wird mit der Einheit 4 vormontiert. Die Einheit 4 wird dann durch die Speicheröffnung in den Speicher 3 eingeführt, bis die Flächen 24, 26 aneinander anliegen und der Mantel des Gliedes 6 den Halsflansch übergreift. Dadurch sind die Einheiten 2, 3 gegeneinander genau zentriert. Nun werden sie unter Druckbelastung der Einheit 20 gegeneinander gespannt. Der Mantelrand des Krimpringes 6 wird dabei radial nach innen unter die Ringschulter des Halsflansches so umgebördelt, daß die Axialspannung permanent aufrecht erhalten bleibt. Beim ersten Betätigungshub der Pumpe 2 wird zunächst die Kammer 11 durch das Ventil 15 und den Kanal 13 entlüftet. Dann wird sie beim Rückhub aus der Kammer 35 mit Medium gefüllt. Dabei ist das Ventil 15 geschlossen und das Ventil 14 geöffnet. Durch die Entnahme entsteht in der Kammer 35 ein Unterdruck. Dieser hält bei geschlossenem Ventil 15 auch das Ventil 14 geschlossen. Der Unterdruck wird jedoch durch Luft ausgeglichen, welche durch die Einheit 20 in die Kammer 35 nachgesaugt wird. Auf die gleiche Weise arbeitet die Vorrichtung 1 bie jedem weiteren Austraghub.

Das Ventil 36 zur Schließung der Belüftungswege des Raumes 19 weist zwei Ventilteile auf. Sie werden mit Beginn des Betätigungshubes zur Ventilöffnung voneinander abehoben. Der eine Ventilteil ist durch eine äußere Ringschulter des Kolbens 17 und der andere Ventilteil durch eine Ringkante an demjenigen Innenumfang des Schließteiles 8 gebildet, welcher vom Kolbenstößel 18 durchsetzt ist. In der Schließstellung werden die Schließflächen des Ventiles 36 durch die Rückstellfeder gegeneinander angeschlagen. Dadurch kann auch die Einheit 5 in der Ausgangsstellung festgesetzt sein. In allen übrigen Stellungen ist das Ventil 36 geöffnet. Der Raum 19 ist durch die Kolbenlippe gegenüber der Kammer 11 ständig abgedichtet. Auch durch den Mantel 7 kann keine Luft in die Kammer 34, 35 gelangen.

Gemäß Fig. 2 ist im Belüftungsweg der Einheit 20 ein Ventil 30 angeordnet. Er öffnet bei Unterdruck in der Kammer 34, 35 und schließt nach Druckausgleich stets wieder. Der bewegbare Ventilkörper 37 deckt in der Schließstellung den Auslaß 32 ab und gibt ihn in der Öffnungsstellung frei. Der platten- oder ringscheibenförmige Ventilteil 37 ist durch rückfedernde Auslenkung in die Speicheröffnung und den Ringraum 34 hinein bewegbar. In der Schließstellung deckt er die zugehörige Plattenfläche der Lage 21 ab. Seine nicht bewegbare Basis kann zwischen den Flächen 26, 27 eingespannt sein und unmittelbar an der Lage 21 sowie der Fläche 26 anliegen. Ferner kann das Ventil 30 zur vormontierten Einheit 2 bzw. 20 gehören. Insbesondere kann der Ventilteil 37 einteilig mit der Lage 22a ausgebildet und durch deren radial inneren Ringrand gebildet sein. Der Innenumfang des Ventilteiles 37 liegt in der Schließstellung zweckmäßig am Außenumfang des Mantels 7 über den Umfang ununterbrochen dicht an. In der Öffnungsstellung dagegen gibt er einen über den Umfang durchgehenden Ringspalt frei, welcher an den Mantel 7 angrenzt.

Gemäß Fig. 2 ist eine der Gegenflächen, nämlich die Gegenfläche 25a, unmittelbar durch die Lage 21 gebildet. Zwischen den Flächen 25a, 27 ist keine gesonderte Dichtung vorgesehen. Diese Spaltabdichtung ist unmittelbar durch die genannten Flächen gebildet. Dadurch ist der durch die Stirnseite der Lage 21 gebildete Anteil des Einlasses 31 wesentlich größer. Dieser Anteil grenzt an den Außenumfang des Flansches 9 an und liegt der Öffnung 33 mit Abstand unmittelbar gegenüber. Der Außenumfang der Scheibe 22a kann daher bis an den Außenumfang der Lage 21 reichen. Die kleinsten Innenumfänge aller Lagen 21 bis 23 bzw. 21, 22a können gleich weit sein.

Die Pumpe 2 ist erfindungsgemäß unter Zwischenlage einer Dichtung an einem Speichergefäß 3 befestigt und die Dichtung enthält eine Filtereinheit 20. Dadurch kann in die Speicherkammer 35 im Zuge ihrer Entleerung gefilterte Außenluft nachgefüllt werden. Die Luft kann nicht durch das Innere der Pumpe 2 hindurchströmen. Außerdem kann der Filter 21 erst beim Zusammenbau von Pumpe und Speicher den Erfordernissen entsprechend ausgewählt werden. Ferner ist die Montage vereinfacht und eine gesonderte Halterung für den Filter 21 nicht erforderlich. Alle Eigenschaften und Wirkungen können genau wie beschrieben oder nur annähernd bzw. im wesentlichen wie beschrieben vorgesehen sein.

Die radial äußere Kante des Filters (21) kann auch radial innerhalb der entsprechenden äußeren Kanten der Dichtungen (21, 22, 22a) bzw. der Fläche (27) und des Flansches (9) liegen. Ferner kann der Filter (21) dünner als jede der Dichtungen (21, 22, 22a) sein. In axialansicht ist der einzige Durchlass (32) spitz V-förmig mit einer V-Höhe von weniger als 1 Millimeter und mit einem Flankenwinkel von weniger als 90° bzw. 70°, wobei er in einer Axialebene der Achse 10 liegt.

## Patentansprüche

1. Austragvorrichtung für Medien, mit einer durch Zusammenfügen an einer Speichereinheit (3) für Medium im Bereich von deren Speicheröffnung einer Speicherkammer (35) anzuordnenden Abgabeeinheit (2), die innerhalb der Außenseite eines Grundkörpers (4, 5) von einem an die Speicherkammer (35) anzuschließenden Einlaß (12) bis zu einem Medienauslaß reichende Medienwege (11 bis 13) einschließlich einer Medienkammer (11) enthält und zum im wesentlichen abgedichteten Verschluß der Speicherkammer (35) beim Medienaustrag aus dem vom Einlaß (12) gesonderten Medienauslaß ausgebildet ist, sowie mit einer zur Belüftung der Speicherkammer (35) mit einem Füllmedium, wie Außenluft, vorgesehenen Belüftungseinrichtung, die in einem Belüftungsweg eine für ihre Lagesicherung mindestens eine Gegenfläche (24) zur Abstützung und Anlage an einer Haltefläche (26) der Speichereinheit (3) aufweisende Filtereinheit (20) mit einem Filter (21) enthält, welcher einen Filtereinlaß (31) und einen in die Speicherkammer (35) mündenden Filterauslaß (32) der Filtereinheit (20) aufweist, **dadurch gekennzeichnet**, daß der Spender (1) den Filter (21) zwischen einem Spannglied (9) und der Speichereinheit (3) verspannt und daß der Filter (21) der verspannten Filtereinheit (20) zwischen deren Spann-Gegenflächen (24, 25) vom Filtereinlaß (31) bis zum Filterauslaß (32) durch das Füllmedium durchströmbar ist.

2. Austragvorrichtung nach Anspruch 1, **dadurch gekennzeichnet,** daß das Spannglied (9) zum axialen Zusammenfügen mit der Speichereinheit (3) ausgebildet ist, daß insbesondere das Spannglied (9) ein Bestandteil der Abgabeeinheit (2) ist und daß vorzugsweise die mit der Abgabeeinheit (2) lagefest an der Speichereinheit (3) zu montierende Filtereinheit (20) zur Abstützung im Bereich der die Abgabeeinheit (2) aufnehmenden Speicheröffnung der Speichereinheit (3) ausgebildet ist.

3. Austragvorrichtung nach Anspruch 1 oder 2, **dadurch gekennzeichnet**, daß die Filtereinheit (20) eine innere Kante, eine äußere Kante sowie als Gegenflächen (24, 25; 25a) voneinander abgekehrte Stirnflächen aufweist, daß insbesondere die Filtereinheit (20) als über den Umfang ununterbrochen durchgehende Ringscheibe ausgebildet ist und daß vorzugsweise eine Gegenfläche (24) der Filtereinheit (20) zur Anlage an einer Stirnfläche (26) der Speichereinheit (3) ausgebildet ist.

4. Austragvorrichtung nach einem der vorhergehenden Ansprüche, **dadurch gekennzeichnet**, daß die Abgabeeinheit (2) ein die Medienkammer (11) mit der Innenseite einer Gehäusewandung (7) begrenzendes Gehäuse aufweist und die Filtereinheit (20) an der Außenseite dieser Gehäusewandung (7) liegt, daß insbesondere die Filtereinheit (20) an die Außenseite des Gehäuses anschließt und daß vorzugsweise die Filtereinheit (20) axial auf die Außenseite der Abgabeeinheit (2) aufgesteckt ist.

5. Austragvorrichtung nach einem der vorhergehenden Ansprüche, **dadurch gekennzeichnet**, daß zur Abdichtung der Speicheröffnung im Bereich der Filtereinheit (20) Dichtmittel vorgesehen sind, daß insbesondere Dichtmittel unmittelbar mit der Filtereinheit (20) verbunden sind und daß vorzugsweise Dichtmittel durch die Filtereinheit (20) gebildet sind.

6. Austragvorrichtung nach einem der vorhergehenden Ansprüche, **dadurch gekennzeichnet**, daß die Filtereinheit (20) mehrlagig mit mindestens einer gasundurchlässigen Lage (22, 23) ist, daß insbesondere mindestens eine nicht filternde Lage (22, 23) die Gegenfläche (24, 25) bildet und daß vorzugsweise ein Filterelement (21) zwischen zwei Dichtelementen (22, 23) angeordnet ist.

7. Austragvorrichtung nach einem der vorhergehenden Ansprüche, **dadurch gekennzeichnet**, daß die Filtereinheit (20) vom Belüftungsstrom radial durchströmt ist, daß insbesondere die Filtereinheit (20) zur Achse (10) der Abgabeeinheit (2) hin gerichtet zwischen zwei Plattenflächen durchströmt ist und daß vorzugsweise die Filtereinheit (20) einen axialen Ausgang (32) für den Belüftungsstrom aufweist.

8. Austragvorrichtung nach einem der vorhergehenden Ansprüche, **dadurch gekennzeichnet**, daß im Belüftungsweg ein in eine Öffnungsstellung überführbarer Verschluß, wie ein druckgesteuertes Ventil (30) o. dgl., vorgesehen ist, daß insbesondere der Verschluß (30) einen plattenförmigen, durch Biegung auslenkbaren Verschlußteil (37) aufweist und daß vorzugsweise der Verschluß (30) durch mindestens ein Element (21, 22a) der Filtereinheit (20) gebildet ist.

9. Austragvorrichtung nach einem der vorhergehenden Ansprüche, **dadurch gekennzeichnet**, daß die Filtereinheit (20) radial sowie axial im wesentlichen außerhalb der Speicheröffnung und der Speichereinheit (3) in einer Filterkammer (29) angeordnet ist, daß insbesondere die Filterkammer (29) am Außenumfang von einem Befestigungsglied (6), wie einem Krimpring, begrenzt ist, welcher zur lagefesten Verspannung der Abgabeeinheit (2) gegenüber der Speichereinheit (3) vorgesehen ist und daß vorzugsweise eine Wandung des Befestigungsgliedes (6) von einer Belüftungsöffnung (33) durchsetzt ist.

10. Austragvorrichtung nach einem der vorhergehenden Ansprüche, **dadurch gekennzeichnet**, daß die Belüftungswege im wesentlichen vollständig gesondert von den Medienwegen und von der Außenseite der Abgabeeinheit (2) begrenzt sind, daß insbesondere die Filtereinheit (20) zwischen einer ringförmigen Flanschfläche (27) der Abgabeeinheit (2) und der Endfläche (26) der Speichereinheit (3) angeordnet ist, wobei die Flanschfläche (27) den Außenumfang der Gehäusewandung (7) und die Endfläche (26) die Speicheröffnung umgibt, und daß vorzugsweise die Abgabeeinheit (2) eine Pumpe, wie eine Schubkolbenpumpe, enthält, deren Medienwege (11 bis 13) wenigstens in der Ausgangsstellung dicht geschlossen sind.

11. Austragvorrichtung nach einem der vorhergehenden Ansprüche, **dadurch gekennzeichnet**, daß die Filtereinheit (20) einen Membranfilter (21) enthält, daß insbesondere die Filtereinheit (20) semipermeabel ist und daß vorzugsweise ein Filter (21) der Filtereinheit (20) aus einem gesinterten Werkstoff besteht.

## Claims

1. A media discharge device comprising a dispensing unit (2) to be arranged by assembly on a reservoir unit (3) for a medium in the region of a reservoir opening of a reservoir chamber (35), said dispensing unit including within the outer side of a base body (4, 5) paths (11 to 13) for the medium extending from an inlet (12) to be connected to said reservoir chamber (35) up to a medium orifice including a medium chamber (11) and is configured for the substantially sealed closure of said reservoir chamber (35) on discharge of the medium from the medium orifice separate from said inlet (12), as well as an aerating means for aerating said reservoir chamber (35) with a filler medium, such as outside air, said aerating means containing in an aeration path a filter unit (20) comprising for positional location at least one counter surface area (24) for support and contact with a holding surface area (26) of the reservoir unit 3, said filter unit (20) containing a filter (21) comprising a filter inlet (31) and a filter outlet (32) of said filter unit (20) porting into said reservoir chamber (35), wherein said dispenser (1) tension-mounts said filter (21) between a clamping member (9) and said reservoir unit (3) and said filter (21) of said tension-mounted filter unit (20) between said tensioning counter surface areas (24, 25) thereof permits passage of said filler medium from said filter inlet (31) to said filter outlet (32).

2. The discharge device as set forth in claim 1, wherein said clamping member (9) is configured for axial assembly with said reservoir unit (3), more particularly said clamping member (9) being a component of said dispensing unit (2) and preferably said filter unit (20) to be assembled with said dispensing unit (2) positionally located on said reservoir unit (3) being configured for support in the region of the reservoir opening, mounting said dispensing unit (2), of said reservoir unit (3) .

3. The discharge device as set forth in claim 1 or 2, wherein said filter unit (20) comprises an inner rim, an outer rim as well as face surface areas facing away from each other as counter surface areas (24, 25; 25a), more particularly said filter unit (20) being configured as an annular disk continuously covering the circumference throughout and preferably one counter surface area (24) of said filter unit (20) being configured for contact with a face surface area (26) of said reservoir unit (3).

4. The discharge device as set forth in any of the preceding claims, wherein said dispensing unit (2) comprises a housing defining said medium chamber (11) by the inner side of a housing wall (7) and said filter unit (20) is located at the outer side of said housing wall (7), more particularly said filter unit (20) adjoining the outer side of said housing and preferably said filter unit (20) being mounted axially on the outer side of said dispensing unit (2).

5. The discharge device as set forth in any of the preceding claims, wherein for sealing said reservoir opening in the region of said filter unit (20) sealing means are provided, more particularly said sealing means being directly connected to said filter unit (20) and preferably said sealing means being formed by said filter unit (20).

6. The discharge device as set forth in any of the preceding claims, wherein said filter unit (20) is a multilayer configuration having at least one gas-impermeable layer (22, 23), more particularly at least one non-filtering layer (22, 23) forming said counter surface area (24, 25) and preferably a filter element (21) being arranged between two sealing elements (22, 23).

7. The discharge device as set forth in any of the preceding claims, wherein the aeration flow passes radially through said filter unit (20), more particularly said flow passing through said filter unit (20) between two plate surface areas oriented towards the axis (10) of said dispensing unit (2) and preferably said filter unit (20) comprising an axial output (32) for said aeration flow.

8. The discharge device as set forth in any of the preceding claims, wherein in said aeration path a closure, such as a pressure-controlled valve (30) or the like is provided translatable into an opening position, more particularly said closure (30) comprising a bendingly deflectable plate-shaped closure part (37) and preferably said closure (30) being formed by at least one element (21, 22a) of said filter unit (20).

9. The discharge device as set forth in any of the preceding claims, wherein said filter unit (20) is arranged both radially and axially substantially outside of said reservoir opening and said reservoir unit (3) in a filter chamber (29), more particularly said filter chamber (29) being defined at the outer circumference by a fastener member (6), such as a crimp ring, provided for positionally locating the clamping of said dispensing unit (2) with respect to said reservoir unit (3) and preferably an aeration opening (33) passing through one wall of said fastener member (6).

10. The discharge device as set forth in any of the preceding claims, wherein said aeration paths are defined substantially totally separately from the paths of the medium and from the outer side of said dispensing unit (2), more particularly said filter unit (20) being arranged between an annular flange surface area (27) of said dispensing unit (2) and said end surface area (26) of said reservoir unit (3), said flange surface area (27) surrounding the outer circumference of said housing wall (7) and said end surface area (26) surrounding said reservoir opening, and preferably said dispensing unit (2) comprising a pump, such as a plunger pump, the medium paths (11 to 13) of the latter being sealingly closed at least in the starting position.

11. The discharge device as set forth in any of the preceding claims, wherein said filter unit (20) comprises a diaphragm filter (21), more particularly said filter unit (20) being semi-permeable and preferably one filter (21) of said filter unit (20) consisting of a sintered material.

## Revendications

1. Dispositif de décharge pour matières, avec un'unité de dégagement (2) à disposer par assemblage à un'unité-réservoir (3) pour une matière dans le domaine de l'ouverture de réservoir de celle-ci d'une chambre à réservoir (35), unité de dégagement qui contient à l'intérieur d'un côté extérieur d'un corps de base (4, 5) des parcours de matière (de 11 à 13) s'étendant à partir d'un moyen d'amission (12) à raccorder à la chambre à réservoir (35) jusqu'à une sortie de matière y compris une chambre à matière (11) et qui est réalisée pour une fermeture essentiellement étanche sous pression de la chambre à réservoir (35) pendant la décharge de matière hors de la sortie de matière qui est séparée de l'entrée (12), ainsi que avec un moyen d'aération prévu pour une aération de la chambre à réservoir (35) par une matière de remplissage, tel que l'air, moyen d'aération qui comprend dans une voie d'aération un'unité de filtrage (20) présentant pour son assurage de position au moins une contre-surface (24) pour le soutien et pour la disposition auprès d'une surface de support (26) de l'unité-réservoir (3), avec un filtre (21), lequel présente une entrée de filtre (31) et une sortie de filtre (32) débouchant dans la chambre à réservoir (35), de l'unité de filtrage (20), **caractérisé en ce que** le distributeur (1) serre le filtre (21) entre un élément de serrage (9) et un'unité-réservoir (3), et en ce que le filtre (21) de l'unité de filtrage (20) serré peut être traversé entre ses contre-surfaces de serrage (24, 25) à partir de l'entrée de filtre (31) jusqu'à la sortie de filtre (32) par la matière de remplissage.

2. Dispositif de décharge d'après la revendication 1, **caractérisé en ce que** l'élément de serrage (9) est réalisé pour un assemblage axial avec l'unité-réservoir (3), en ce que notamment l'élément de serrage (9) est une composante de l'unité de dégagement (2) et en ce que de préférence l'unité de filtrage (20), à monter en position fixe avec l'unité de dégagement (2) à l'unité-réservoir (3), est réalisée pour un support dans le domaine de l'ouverture de réservoir, logeant l'unité de dégagement (2), de l'unité-réservoir (3).

3. Dispositif de décharge d'après la revendication 1 ou 2, **caractérisé en ce que** l'unité de filtrage (20) présente un bord intérieur, un bord extérieur ainsi que des surfaces frontales opposées entr'elles en tant que contre-surfaces (24, 25; 25a), en ce que notamment l'unité de filtrage (20) est réalisée en tant que disque annulaire s'étendant sur la circonférence de manière ininterrompue et en ce que de préférence une contre-surface (24) de l'unité de filtrage (20) est réalisée pour la disposition à une surface frontale (26) de l'unité-réservoir (3).

4. Dispositif de décharge d'après une des revendications précédentes, **caractérisé en ce que** l'unité de dégagement (2) présente un boîtier délimitant avec la face intérieure d'une paroi de boîtier (7) la chambre à matière (11) et que l'unité de filtrage(20)se trouve du côté extérieur de cette paroi de boîtier (7), en ce que notamment l'unité de filtrage (20) fait suite à la surface extérieure du boîtier et en ce que de préférence l'unité de filtrage (20) est placée axialement au-dessus du côté extérieur de l'unité de dégagement (2).

5. Dispositif de décharge d'après une des revendications précédentes, **caractérisé en ce que** pour l'étanchement de l'ouverture de réservoir dans le domaine de l'unité de filtrage (20) sont prévus des moyens d'étanchement, en ce que notamment des moyens d'étanchement sont raccordés directement avec l'unité de filtrage (20) et en ce que de préférence des moyens d'étanchement sont formés par l'unité de filtrage (20).

6. Dispositif de décharge d'après une des revendications précédentes, **caractérisé en ce que** l'unité de filtrage (20) est en plusieurs couches avec au moins une couche imperméable aux gaz (22, 23), en ce que notamment au moins une couche non filtrante (22, 23) constitue la contre-surface (24, 25) et en ce que de préférence un élément de filtre (21) est disposé entre deux éléments d'étanchement (22, 23).

7. Dispositif de décharge d'après une des revendications précédentes, **caractérisé en ce que** l'unité de filtrage (20) est radialement traversée par le courant d'aération, en ce que notamment l'unité de filtrage (20) est traversée entre deux surfaces de plaque en direction de l'axe (10) de l'unité de dégagement (2) et en ce que de préférence l'unité de filtrage (20) présente une sortie axiale (32) pour le courant d'aération.

8. Dispositif de décharge d'après une des revendications précédentes, **caractérisé en ce que** dans le parcours d'aération est prévu un moyen de fermeture pouvant être mis dans une position ouverte, tel qu'une soupape (30) commandée par pression ou similaires, en ce que notamment le moyen de fermeture (30) présente un élément de fermeture (37) en forme de plaque, pouvant être dévié par pliage et en ce que de préférence le moyen de fermeture (30) est constitué d'au moins un élément (21, 22a) de l'unité de filtrage (20).

9. Dispositif de décharge d'après une des revendications précédentes, **caractérisé en ce que** l'unité de filtrage (20) est disposée radialement ainsi que axialement en substance à l'extérieur de l'ouverture de réservoir et de l'unité-réservoir (3) dans une chambre de filtrage (29), en ce que notamment la chambre de filtrage (29) est délimitée à la circonférence extérieure par un élément de fixation (6), tel qu'un anneau à rétrécissement, lequel est prévu pour le serrage en position fixe de l'unité de dégagement (2) par rapport à l'unité-réservoir (3), et en ce que de préférence une paroi de l'élément de fixation (6) est traversée par une ouverture d'aération (33).

10. Dispositif de décharge d'après une des revendications précédentes, **caractérisé en ce que** les parcours d'aération sont délimités en substance séparément des parcours de matière et de la face extérieure de l'unité de dégagement (2), en ce que notamment l'unité de filtrage (20) est disposée entre une surface de bride (27) de forme annulaire de l'unité de dégagement (2) et de la surface terminale (26) de l'unité-réservoir (3), tandis que la surface de bride (27) entoure le périmètre extérieur de la paroi de boîtier (7) et la surface terminale (26) entoure l'ouverture de réservoir, et en ce que de préférence l'unité de dégagement (2) comprend une pompe, telle qu'une pompe à piston mouvant, dont les parcours de matière (de 11 à 13) sont fermés de manière étanche au moins dans la position initiale.

11. Dispositif de décharge d'après une des revendications précédentes, **caractérisé en ce que** l'unité de filtrage (20) contient une membrane filtrante (21), en ce que notamment l'unité de filtrage (20) est semi-perméable et en ce que de préférence un filtre (21) de l'unité de filtrage (20) est constituée d'une substance frittée.
